# EUROPEAN PATENT APPLICATION

(11) **EP 4 521 867 A1**
(43) Date of publication of application: **12.03.2025**
(21) Application number: 23196087.3
(22) Date of filing: 07.09.2023
(51) Int. Cl.: H05K 7/20

(54) **TELEMATICS CONTROL UNIT FOR A VEHICLE**

(71) Applicant: Valeo Comfort and Driving Assistance, 94000 Créteil (FR)
(72) Inventor: HALMANDGE, Veerappa, 94000 Créteil (FR); KOVACS, Kristof, 94000 Créteil (FR); REICHERT, Walter, 94000 Créteil (FR)
(74) Representative: Delplanque, Arnaud

(57) **Abstract**

The invention relates to a telematics control unit (1) for a vehicle (2), said telematics control unit (1) comprising :
- a housing (10) extending along a longitudinal axis,
- an electronic support (11) that is configured to support a plurality of electronic components (110), said electronic support (11) being disposed inside the housing (10),
- a heatsink (12) that is configured to cool said plurality of electronic components (110),
- a fan (13) that is configured to draw some environmental air (F) inside said housing (10),
- a cover (14) that is configured to close said housing (10), wherein :
- said cover (14) comprises a first part (140) that is configured to be assembled to the housing (10) and a second part (141),
- said housing (10) and said at least one heatsink (12) define a first air flow channel (15) arranged on one side (11.1) of the electronic support (11), said first air flow channel (15) being configured to guide a first part of the environmental air (F),
- the first part (140) and the second part (141) of the cover (14) define a second air flow channel (16) arranged on the other side (11.2) of the electronic support (11), said second air flow channel (16) being configured to guide a second part of the environmental air (F),
- said fan (13) is configured to drive the environmental air (F) through said first air flow channel (15) and through said second air flow channel (16) so that the environmental air (F) flows along both sides of the electronic support (11).

## Description

### FIELD OF THE INVENTION

The present invention relates to a telematics control unit for a vehicle. Such telematics control unit, may be used, but not exclusively, in the automotive domain.

### BACKGROUND OF THE INVENTION

In the automotive domain, a telematics control unit for a vehicle, well-known by the person skilled in the art, comprises:
- a housing,
- an electronic support with electronic components, said electronic support extending along a longitudinal axis and being disposed inside the housing,
- a heatsink that is configured to cool said electronic components,
- a fan that is configure to draw some environmental air from inside the housing,
- a cover that is configured to close said housing.

The heatsink is disposed on a side of the electronic support opposed to the one where the electronic components are disposed. The fan draws the environmental air through an air flow channel that is arranged on the same side of the heatsink.

One problem of this prior art is that depending on the number of the electronic components disposed on the electronic support, or on the amount of heat radiated by the electronic components, the cooling can be insufficient.

It is an object of the invention to provide a telematics control unit for a vehicle, which resolves the problem above-stated.

### SUMMARY OF THE INVENTION

To this end, it is provided a telematics control unit for a vehicle said telematics control unit comprising :
- a housing extending along a longitudinal axis,
- an electronic support that is configured to support a plurality of electronic components, said electronic support being disposed inside the housing,
- a heatsink that is configured to cool said plurality of electronic components,
- a fan that is configured to draw some environmental air inside said housing,
- a cover that is configured to close said housing, wherein :
- said cover comprises a first part that is configured to be assembled to the housing and a second part,
- said housing and said at least one heatsink define a first air flow channel arranged on one side of the electronic support, said first air flow channel being configured to guide a first part of the environmental air,
- the first part and the second part of the cover define a second air flow channel arranged on the other side of the electronic support, said second air flow channel being configured to guide a second part of the environmental air,
- said fan is configured to drive the environmental air through said first air flow channel and through said second air flow channel so that the environmental air flows along both sides of the electronic support.

As we will see in further details, thanks to both air flow channels, both sides of the electronic support can be cooled. The cooling is therefore sufficient whatever the number of different electronic components disposed on the electronic support.

According to non-limitative embodiments of the invention, the telematics control unit for a vehicle further comprises the following characteristics.

In a non-limitative embodiment, said fan is arranged on a side of the housing and is an axial fan or a radial fan.

In a non-limitative embodiment, said fan has an axis that is tilted angle compared to a transversal axis of the housing, said transversal axis being perpendicular to the longitudinal axis.

In a non-limitative embodiment, the first air flow channel and the second air flow channel extend along a transversal axis that is perpendicular to the longitudinal axis.

In a non-limitative embodiment, said fan is configured to take the environmental air from one side of the housing and to evacuate it from another other side of the housing outside said housing through said first air flow channel and said second air flow channel.

In a non-limitative embodiment, said housing further comprises a recess to receive the heatsink, said recess having a slope.

In a non-limitative embodiment, said housing is of a metal material or of a thermoplastic material.

In a non-limitative embodiment, said cover is of a thermoplastic material.

In a non-limitative embodiment, said heatsink is a sheet of metal or a die casting part with fins.

In a non-limitative embodiment, said heatsink is embedded or molded into the housing.

In a non-limitative embodiment, said first part of the cover comprises cooling fins.

In a non-limitative embodiment, the plurality of electronic components are disposed on one side of the electronic support or on both sides of the electronic support.

In a non-limitative embodiment, said electronic support is a printed circuit board assembly.

In a non-limitative embodiment, the environmental air is separated in two different sub-air flows, a first sub-air flow flowing through the first air flow channel and a second sub-air flow flowing through the second air flow channel.

In a first non-limitative variant of embodiment, when the axis of the fan is tilted angle so that more environmental air is blowing on the other side of the electronic support, the housing embeds some cooling fins to compensate the decrease in the air flow on the one side of the electronic support. Conversely, in a second non-limitative embodiment, when the axis of the fan is tilted angle so that more air are blowing on the one side of the electronic support, the cover embeds some cooling fins to compensate the decrease in the environmental air flow on the other side of the electronic support.

In a non-limitative embodiment, the slope is partitioned in compartments.

In a non-limitative embodiment, the cooling fins extend partly on the first part of the cover. They are positioned opposite to the second part of the cover.

In a non-limitative embodiment, The first part comprises a protruding portion from which the cooling fins arise.

In a non-limitative embodiment, the one side and the other side of the housing are opposed to each other.

### BRIEF DESCRIPTION OF THE DRAWINGS

Some embodiments of methods and/or system in accordance with embodiments of the present invention are now described, by way of example only, and with reference to the accompanying drawings, in which:
Figure 1 is a schematic illustration of a telematics control unit for a vehicle according to a non-limitative embodiment of the invention, said telematics control unit comprising a housing, an electronic support, a heatsink, a fan, and a cover,
Figure 2 is an exploded view in perspective of the telematics control unit of figure 1 according to a non-limitative embodiment,
Figure 3 is an assembled view in perspective of the telematics control unit of figure 2,
Figure 4 is a side view of the telematics control unit of figure 3,
Figure 5 is a top view of the housing of the telematics control unit of figure 2,
Figure 6 is a bottom view of the housing of the telematics control unit of figure 2,
Figure 7 is a zoom on part of the housing that is configured to receive said fan of telematics control unit of figure 2, said part together with said heatsink defining a first air flow channel,
Figure 8a is a longitudinal sectional view of figure 7,
Figure 8b is a zoom on part of figure 8a,
Figure 9a is a top view in perspective of the electronic support of the telematics control unit of figure 2,
Figure 9b is a bottom view in perspective of the electronic support of the telematics control unit of figure 2,
Figure 10 is a view of one side of the cover of the telematics control unit of figure 2, said cover comprising a first part and a second part that is a removable part according to a non-limitative embodiment,
Figure 11 is a view of the other side of a first part of the cover of the telematics control unit of figure 2,
Figure 12 is the view of the cover of figure 11 with the second part attached to the first part,
Figure 13 is a zoom on the first part of the cover of figure 11, said first part comprising cooling fins according to a non- limitative embodiment,
Figure 14 is a sectional view of the cover of figure 10, where the first part and the second part define a second air flow channel,
Figure 15 is a schematic illustration of a first non-limitative embodiment of the fan of figure 1,
Figure 16 is a schematic illustration of a second non-limitative embodiment of the fan of figure 1,
Figure 17 is a schematic illustration of a third non-limitative embodiment of the fan of figure 1.

### DESCRIPTION OF EMBODIMENTS OF THE INVENTION

In the following description, well-known functions or constructions by the person skilled in the art are not described in detail since they would obscure the invention in unnecessary detail.

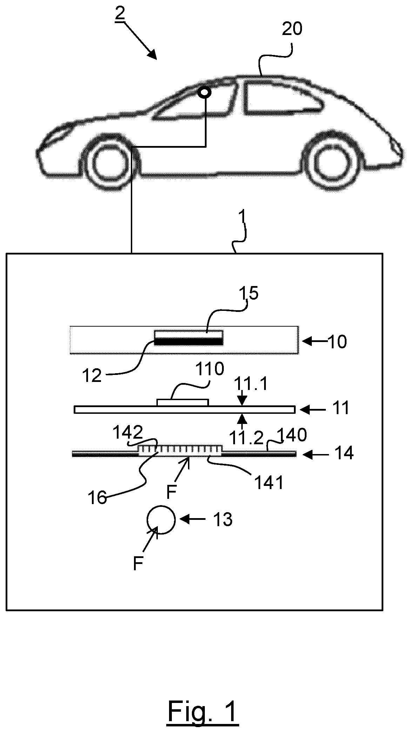

The present invention relates to a telematics control unit 1 for a vehicle 2, said telematics control unit 1 being described in reference to figures 1 to 17. In a non-limitative embodiment, the vehicle 2 is a motor vehicle. In non-limitative variants of embodiment, the motor vehicle 2 has a combustion engine, has an electric engine, or a hybrid engine.

The telematics control unit 1 also referred to as TCU in the following. In a non-limitative embodiment, the TCU is mounted on the roof 20 of the vehicle 2 inside the vehicle 2. This non-limitative embodiment is taken as a non-limitative example in the following.

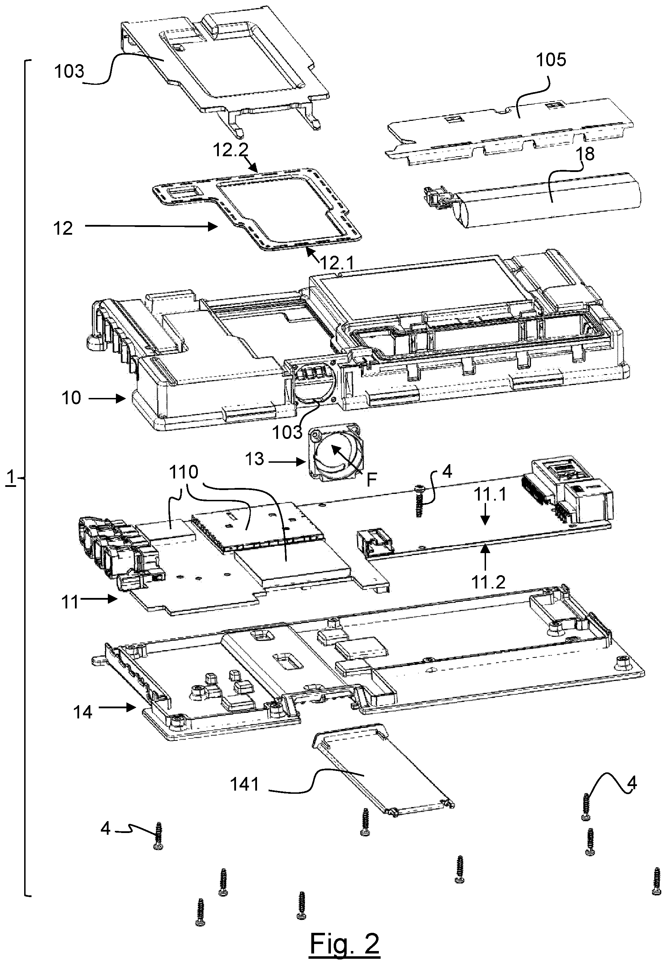

As illustrated in figures 1 and 2, the telematics control unit 1 comprises :
- a housing 10,
- an electronic support 11,
- a heatsink 12,
- a fan 13,
- a cover 14.

These different elements are described in detail hereinafter.

### Housing 10:

The housing 10 is configured to receive the electronic support 11, said heatsink 12, and said fan 13.

The housing 10 has dimensions with a length and a width. In non-limitative embodiments, the length is different from the width or both are equal in dimension.

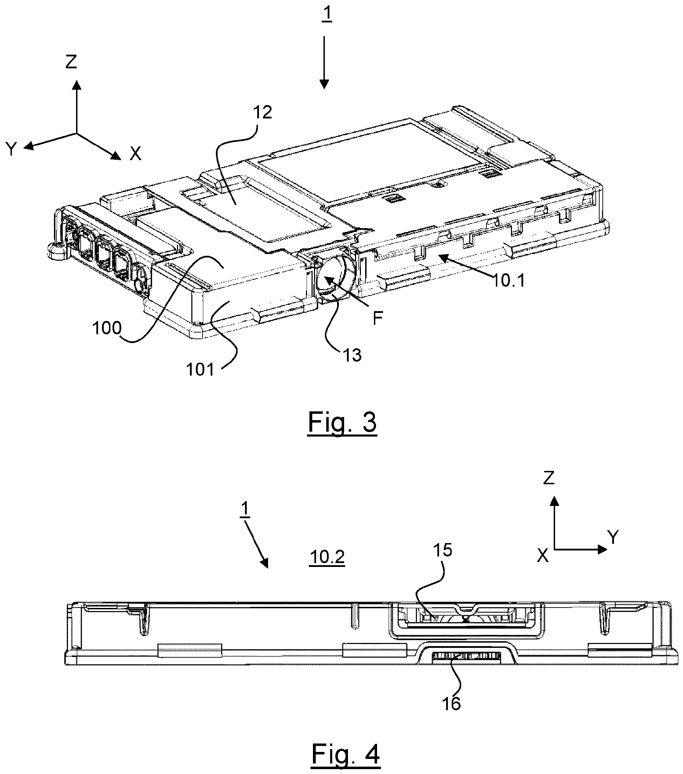

As illustrated in figure 3, the housing 10 extends along a longitudinal axis Y in its length, and along a transversal axis X in its width, said transversal axis X being perpendicular to the longitudinal axis A.

In a non-limitative embodiment, the housing 10 is composed of a first base 100 (as illustrated in figure 3) and a wall 101 (as illustrated in figure 3) that extends from said first base 100. The wall 101 is perpendicular to the first base 100 and extends along a vertical axis Z.

In a non-limitative embodiment, the housing 10 is in contact with the roof 20 of the vehicle 2, in particular with a decorative part, where it can be fixed. In a non-limitative example, it is fixed with screws (not illustrated). Hence, in a non-limitative example, the TCU is placed above the head of the passengers of the vehicle 2.

In a non-limitative embodiment, the housing 10 is of a metal material or of a thermoplastic material. The thermoplastic material is lighter than the metal material and thus cost is reduced.

As illustrated in figure 1, the housing 10 and the heatsink 12 define a first air flow channel 15 arranged on one side of the electronic support 11, here the top side 11.1.

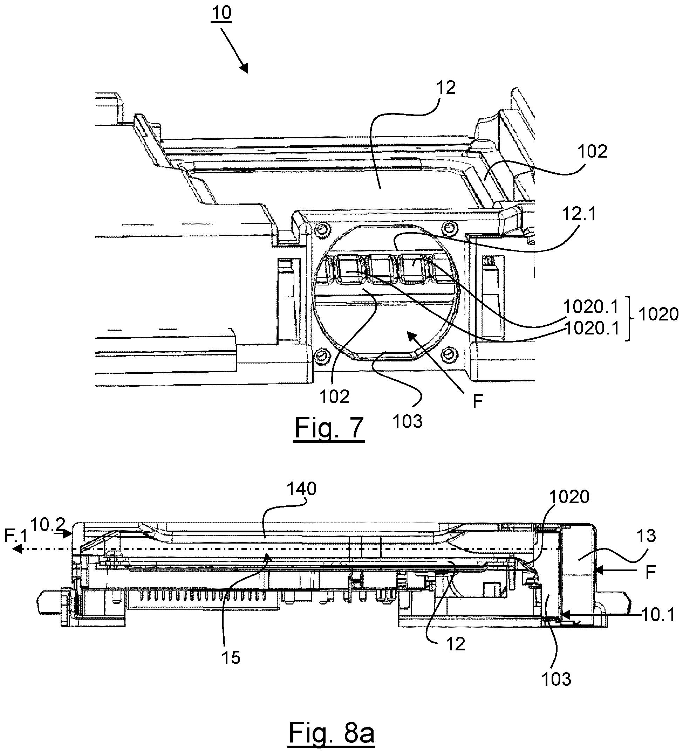

In a non-limitative embodiment illustrated in figures 2 and 7, the housing 10 further comprises an opening 103. The environmental air F that is taken from outside the housing 10 flows through said opening 103. In the following, the environmental air F is also referred to as the air F.

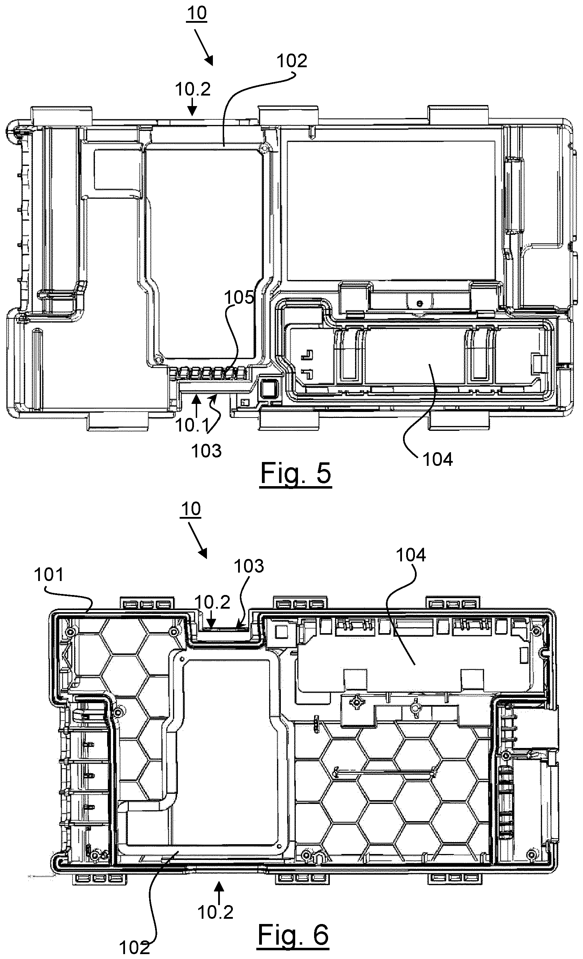

In a non-limitative embodiment illustrated in figures 5 and 6, the housing 10 further comprises a recess 102 to receive the heatsink 12. As illustrated in figures 7 to 8b, the recess 102 has a slope 1020 that permits to enhance the entering of the environmental air F through the first air flow channel 15 described later in the following.

As illustrated in figure 7, in a non-limitative embodiment, the slope 1020 is partitioned in compartments 1020.1. It helps to guide the air F.

In a non-limitative embodiment illustrated in figures 5 and 6, the housing 10 further comprises a supplementary recess 104 to receive a battery 18 illustrated in figure 2. The housing 10 further comprises a flap 105 to close the recess 104.

### Cover 14:

The cover 14 is configured to close the housing 10.

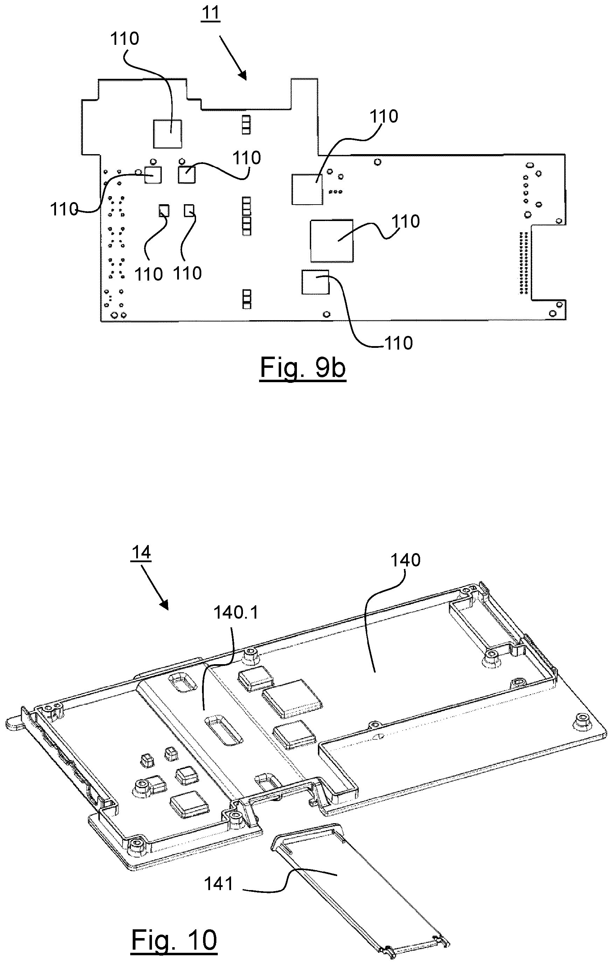

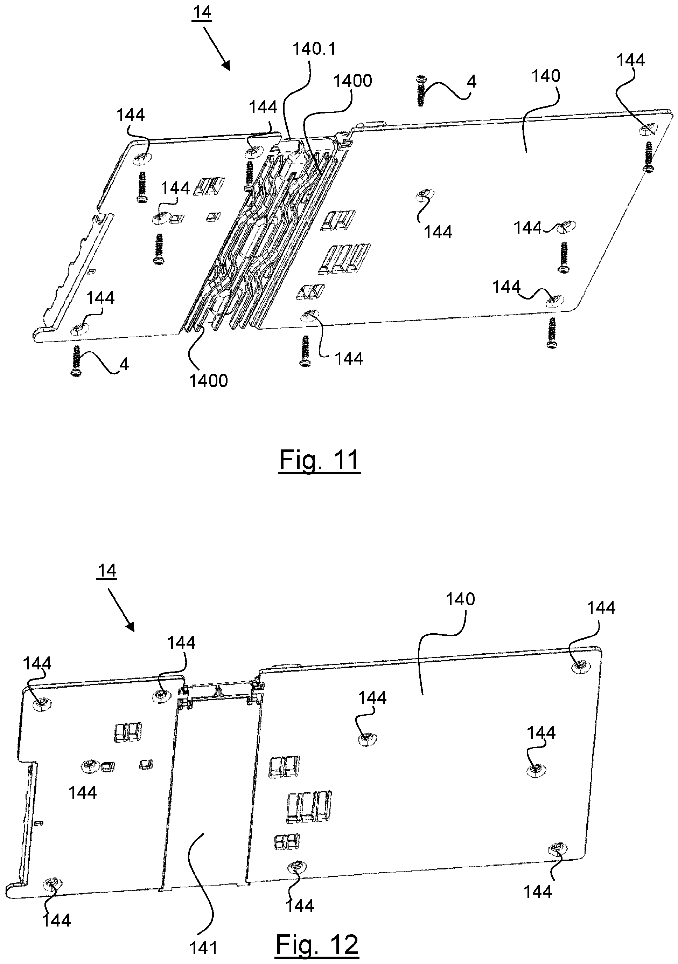

As illustrated in figure 1 and figure 10, the cover 14 comprises a first part 140 and a second part 141. The first part 140 is also called second base 140 in the following and is configured to be attached to the housing 10. It has about the same dimensions as the first base 100 of the housing 10. To this end, as illustrated in figure 11, in a non-limitative embodiment, it comprises holes 144 that are configured to receive some screws 144.

As illustrated in figure 1, the first part 140 and the second part 141 of the cover 14 define a second air flow channel 16 arranged on the other side of the electronic support 11, here the bottom side 11.2.

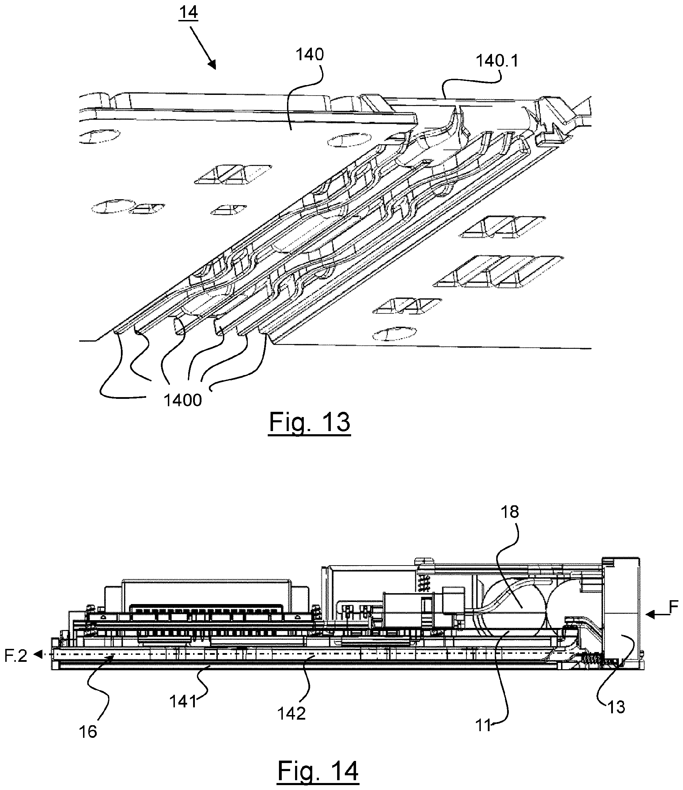

In a non-limitative embodiment illustrated in figures 11 and 13, the first part 140 comprises a plurality of cooling fins 1400. The cooling fins 1400 increase the contact area with the air F. Therefore, more heat can be taken outside the housing 10. The cooling fins 1400 extend partly on the first part 140. They are positioned opposite to the second part 141. The first part 140 thus comprises a protruding portion 140.1 from which said cooling fins 1400 arise.

In a non-limitative embodiment, said second part 141 is removable. It gives flexibility for the assembly and disassembly. The removable part 141 is configured to be attached to the first part 140 as illustrated in figure 12 and to be positioned in regard to the cooling fins 1400.

In a non-limitative embodiment, the first part 140 is of a metal material or of a thermoplastic material. In a non-limitative embodiment, the second part 141 is of a thermoplastic material. It is a material that is cheap. Moreover, with the thermoplastic material, it is easier to fix the cover 14.

### Electronic support 11:

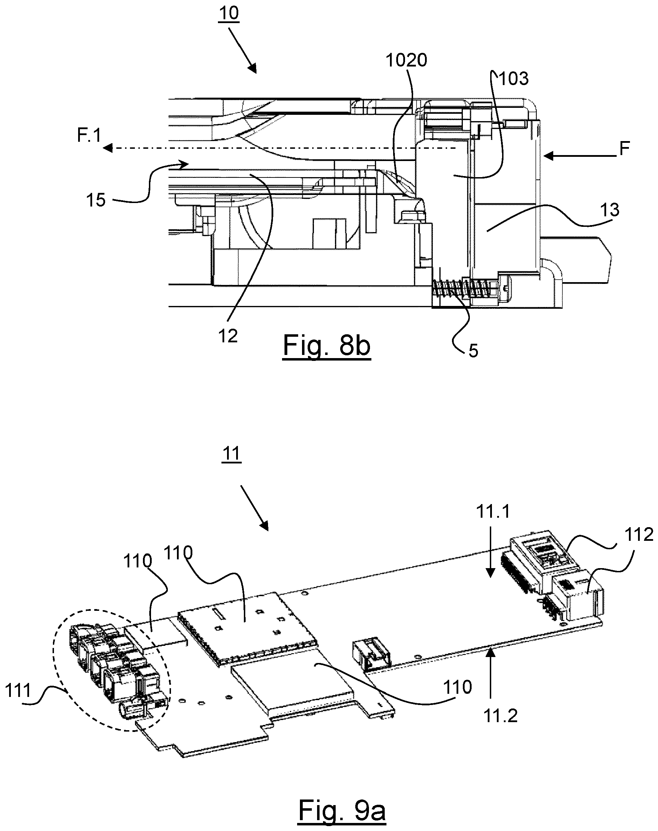

As illustrated in figures 9a and 9b, the electronic support 11 is configured to support a plurality of electronic components 110.

In a non-limitative embodiment, the electronic support 11 is a printed circuit board assembly also referred to as PCBA in the following.

The electronic support 11 extends along the longitudinal axis Y and is parallel to the housing 10 and to the cover 14 when the TCU is assembled. It has a first side 11.1 also referred to as top side 11.1, and a second side 11.2 opposed to the first side 11.1, also referred to as bottom side 11.2.

In a first non-limitative embodiment, the electronic support 11 receives the electronic components 110 on one of its sides. In a second non-limitative embodiment, the electronic support 11 supports the electronic components 110 on both its top side 11.1 as illustrated in figure 9a and its bottom side 11.2 as illustrated in figure 9b.

In a non-limitative embodiment, one of these electronic components 110 is a TCU sensor chip that radiates more heat than the other electronic components. This heat in particular has to be managed.

In a non-limitative embodiment illustrated in figure 9a, the electronic support 11 further comprises first connections 112 and second connections 111. In a non-limitative embodiment, the first connections 112 are configured to receive and to emit some communication signals so that the vehicle 2 communicates with other vehicles, some base stations or any other communication equipment, or with a central control unit of the vehicle 2. In a non-limitative embodiment the second connections 111 are used for power.

### Heatsink 12:

The heatsink 12 is configured to cool the electronic components 110 (in particular the TCU sensor chip) and the electronic support 11.

In a non-limitative embodiment illustrated in figure 1 and 2, the heatsink 12 is disposed on the same side 11.1 of the electronic support 11 where the electronic components 110 are when there are electronic components 110 only on one side of the electronic support 11. In the non-limitative example illustrated, it is disposed in regard to the top side 11.1 of the electronic support 11.

In a non-limitative embodiment illustrated in figure 3, the heatsink 12 extends along the width of the housing 10, i.e. along the transversal axis X.

In a non-limitative embodiment illustrated in figure 2, the heatsink 12 is disposed in regard to the TCU sensor chip so that it can efficiently collect the heat coming from the TCU sensor chip.

In a non-limitative embodiment illustrated in figure 2, the heatsink 12 has dimensions that are arranged so that it covers the dimensions of the electronic component(s) 110 that radiated the most heat, in particular the TCU sensor chip. As illustrated in figure 2, the heatsink 12 is dimensioned in order to cover the three electronic components 110 that are on the top side 11.1 of the electronic support 11 as illustrated in figure 9a.

The heatsink 12 forms with the housing 10, in particular with the first base 140 of the housing 10, the first air flow channel 15. Said first air flow channel 15 is therefore arranged on the top side 11.1 of the electronic support 11.

The heat coming from the electronic components 110 passes through the heatsink 12, is extracted via said heatsink 11 and is blown outside the housing 10 by means of the fan 13 along the first air flow channel 15. It is blown through one side of the housing 10 along the transversal axis X. In a non-limitative limitative example, it is blown through the side 10.2 illustrated in figure 4.

In a first non-limitative embodiment illustrated in figure 2 and 3, the heatsink 12 is a sheet of metal. A sheet of metal can be bent or formed.

In a second non-limitative embodiment (not illustrated), the heatsink 12 is a die casting part with cooling fins. The die casting part is aluminum molded. The cooling fins improve the transmission of the heat from the electronic components 110 to the heatsink 12. With the cooling fins, the area contact with the environmental air F is increased. Therefore, more heat can be evacuated outside the housing 10.

In non-limitative embodiments, the heatsink 12 is embedded or molded into the housing 10, in particular into the base 140.

### Fan 13:

In a non-limitative embodiment illustrated in figure 8a, the fan 13 is arranged on a side 10.1 of the housing 10. It is disposed in regard to the opening 103 (illustrated in figure 8a and 8b) of the housing 10.

In a non-limitative embodiment, the fan 13 is assembled to the housing 10 by means of some screws 5 (illustrated in figure 8b). In figure 8b, only one screw 5 is illustrated as it is a sectional view.

The fan 13 is configured to draw some environmental air F inside said housing 10 as illustrated in figure 3. The environmental air F is coming from outside the housing 10.

The fan 13 is configured to drive the environmental air F through the first air flow channel 15 and through the second air flow channel 16 so that said environmental air F flows along both sides of the electronic support 11. So, the cooling is twice as efficient than when there is only one air flow channel on one side of the electronic support 11. It is to be noted that either the fan 13 blows the environmental air F, or it sucks it.

The fan 13 drives the environmental air F separately along the top side 11.1 and to the bottom side 11.2 of the electronic support 11. Hence, the environmental air F is separated in two different sub-air flows F.1, F.2, the first one F1.1 flowing through the first air flow channel 15 and the second one F.2 flowing through the second air flow channel 16.

The first air flow channel 15 is illustrated in figures 4 and 8a. It is configured to guide a first part F.1 of the environmental air F through the housing 10, here the first sub-air flow F.1. One can see in figure 8a the first sub-air flow F.1 flows along said first air flow channel 15. It permits the evacuation of the heat from the electronic components 110 that are on the top side 11.1 of the electronic support 11 outside the housing 10. Hence, the heat doesn't stay inside the housing 10 and can't heat up the housing 10.

The second air flow channel 16 is illustrated in figures 4 and 14. It is configured to guide a second part F.2 of the environmental air F through the housing 10, here the second sub-air flow F.2. One can see in figure 14 the second sub-air flow F.2 flows along said second air flow channel 16. It permits the evacuation of the heat from the electronic components 110 that are on the bottom side 11.2 of the electronic support 11 outside the housing 10. Hence, the heat doesn't stay inside the housing 10 and can't heat up the housing 10.

Thanks to both air flow channels 15 and 16, the air F doesn't escape in different directions which would reduce the effect of cooling if it was the case.

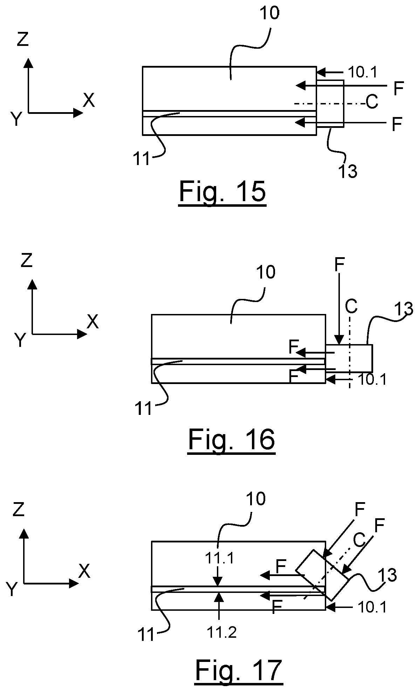

In a first non-limitative embodiment illustrated in figure 3 and 15, the fan 13 is an axial fan. It has an axis C that is parallel to the electronic support 11, and that is parallel to the transversal axis X. It is arranged on one side 10.1 of the housing 10. The fan 13 takes the environmental air F along the axis C and the environmental air F enters the housing 10 along the axis C of the fan 13. Hence, the fan 13 throws air F into the housing 10 along the axis C. It permits to blow the environmental air F directly through the first air flow channel 15 and through the second air flow channel 16. It permits to have a TCU which is more compact as it takes less space than a radial fan.

In a second non-limitative embodiment illustrated in figure 16, the fan 13 is a radial fan. It has an axis C that is perpendicular to the electronic support 11 and that is parallel to the vertical axis Z. It is arranged also on one side 10.1 of the housing 10. The fan 13 takes the environmental air F from top and bottom along its axis C and reorientates it so that the environmental air F enters the housing 10 perpendicular to said axis C like the axial fan in figure 15. It avoids recirculation of the air F that leads to a heating up of said air F, contrary to a solution where a radial fan 13 takes the air F from top and blows it to the bottom of the housing leading to a pre-heating of the air F while flowing to the bottom. When it arrives to the bottom, the air F is heat and therefore it will heat the electronic components that are on the electronic support 11.

In a third non-limitative embodiment illustrated in figure 17, the fan 13 has an axis C that is tilted angle compared to the transversal axis X of the housing 10. It is arranged also on one side 10.1 of the housing 10. The fan 13 takes the environmental air F along the axis C and reorientates it parallel to the transversal axis X on the top side and the bottom side of the electronic support 11. By controlling the fan's axis C direction, one can control the air flow direction. In the non-limitative example illustrated in figure 17, more air will flow on the bottom side 11.2 of the electronic support 11. In non-limitative embodiments, the fan 13 is fixed with screws to the housing 10.

In a first non-limitative variant of embodiment, when the axis C is tilted angle so that more air F is blowing on the bottom side 11.2 of the electronic support 11, the housing 10 embeds some cooling fins to compensate the decrease in the air flow on the top side 11.1 of the electronic support 11. Conversely, when the axis C is tilted angle so that more air is blowing on the top side 11.1 of the electronic support 11, the cover 14 embeds some cooling fins to compensate for the decrease in the air flow on the bottom side 11.2.

As illustrated in figure 4, the first air flow channel 14 and the second air flow channel 15 extends along the transversal axis X.

As illustrated in figure 8a, the first air flow channel 15 has one extremity that opens to one side 10.1 of the housing 10, and has the other extremity that opens to the other side 10.2 of the housing 10. In this manner, the environmental air F is able to enter the first air flow channel 15 from one extremity of said first air flow channel 15 and to flow along the first air flow channel 15 to the other extremity, and to output from one side of the housing 10 outside said housing 10. Thus, it cools the top side 11.1 of the electronic support 11 and therefore the electronic components 110 on this top side 11.1. The first air flow channel 14 is configured to guide a first part F.1 of the environmental air F, which is a sub-air flow F.1. This first sub-air flow F.1 flows along the one side of the electronic support 11 and cools this one side, here the top side 11.1. In the non-limitative example illustrated, the first sub-air flow F.1 enters from the side 10.1 of the housing 10 and outputs to the other side 10.2 of the housing 10. It is the case when the fan 13 blows the environmental air F. It is to be noted that it could be the contrary if the fan 13 sucks the environmental air F. In this latter case, the first sub-air flow F.1 enters the side 10.2 of the housing 10 and output to the other side 10.1 of the housing 10.

In the same manner, as illustrated in figure 14, the second air flow channel 16 has one extremity that opens to one side 10.1 of the housing 10, and has the other extremity that opens to the other side 10.2 of the housing 10. In this manner, the environmental air F is able to enter the second air flow channel 16 from one extremity of said second air flow channel 16 and to flow along the second air flow channel 16 to the other extremity, and to output from one side of the housing 10 outside the housing 10. Thus, it cools the bottom side 11.2 of the electronic support 11. The second air flow channel 15 is configured to guide a second part F.2 of the environmental air F, which is a sub-air flow F.2. This second sub-air flow F.2 flows along the other side of the electronic support 11 and cools this other side, here the bottom side 11.2. In the non-limitative example illustrated, the second sub-air flow F.2 enters from the side 10.1 of the housing 10 and outputs to the other side 10.2 of the housing 10. It is the case when the fan 13 blows the environmental air F. It is to be noted that it could be the contrary if the fan 13 sucks the environmental air F. In this latter case, the second sub-air flow F.2 enters the side 10.2 of the housing 10 and output to the other side 10.1 of the housing 10.

In summary, the fan 13 takes the environmental air F from one side 10.1 of the housing 10 and evacuates it from the other side 10.2 of the housing 10 outside the housing 10 through the first air flow channel 15 and the second air flow channel 16. In a non-limitative embodiment illustrated in figures 5 or 8a, the one side 10.1 and the other side 10.2 of the housing 10 are opposed to each other, that is to say, they are arranged opposite to each other along the transversal axis X. The first air flow channel 15 and the second air flow channel 16 are therefore straight.

When considering the side view of figure 4, the second air flow channel 16 is arranged above the first air flow channel 15 along the vertical axis Z. Thanks to these two independent air flow channels 15 and 16, the fan 13 blows separately the environmental air F to the top side 11.1 and to the bottom side 11.2 of the electronic support 11. The fan 13 takes fresh air from outside the housing 10 for the top side 11.1 and also for the bottom side 11.2 of the electronic support 11 so that there is no recirculation of air from one side to another side of the electronic support 11. As can be seen, the air flow channels 15 and 16 are straight and have minimum bends or no bend at all. They are short compared to an air flow channel with a bend that is to say with angular direction.

As they are straight and short, one doesn't need a powerful fan 13. Thus, one reduces the noise as the noise increases when the power of the fan 13 increases. Thus, one also reduces the dimension of the fan 13. A bigger fan leads to reducing the place for the layout of the electronic components.

As they are straight, there is less back pressure on the air flow contrary to an air flow channel with a bent of 90 degrees for example. Hence, with straight air flow channels, the air flow is not restricted and more air is flowing through the air flow channels.

With short air flow channels, it reduces the air flow resistance. Hence, it doesn't add up to the noise of the fan 13.

It is to be understood that the present invention is not limited to the aforementioned embodiments and variations and modifications may be made without departing from the scope of the invention. All statements herein reciting principles, aspects, and embodiments of the invention, as well as specific examples thereof, are intended to encompass equivalents thereof. In this respect, the following remarks are made. Hence, in another non-limitative application, the electronic device 1 is an electronic device used for computers or any other applications different from the automotive application. Hence, in another non-limitative embodiment, the telematics control unit 1 comprises another heatsink that is arranged opposite to the bottom side 11.2 of the electronic support 11. It replaces the cooling fins 1400 of the cover 14. Hence, the TCU comprises more than one heatsink.

Hence, some embodiments of the invention may comprise one or a plurality of the following advantages:
- it permits an efficient cooling when electronic components 110 are on one side or on both sides of the electronic support 11, as with the first air flow channel 15 and the second air flow channel 16, it cools respectively both side of the electronic support 11,
- thanks to both air flow channels15 and 16, it permits to control both air flows independently,
- it is less noisy than a solution where an air flow channel comprises a bend,
- it avoids recirculation of pre-heating air from one side to another side of the electronic support.

## Claims

1. Telematics control unit (1) for a vehicle (2), said telematics control unit (1) comprising :
- a housing (10) extending along a longitudinal axis (Y),
- an electronic support (11) that is configured to support a plurality of electronic components (110), said electronic support (11) being disposed inside the housing (10),
- a heatsink (12) that is configured to cool said plurality of electronic components (110),
- a fan (13) that is configured to draw some environmental air (F) inside said housing (10),
- a cover (14) that is configured to close said housing (10), wherein :
- said cover (14) comprises a first part (140) that is configured to be assembled to the housing (10) and a second part (141),
- said housing (10) and said at least one heatsink (12) define a first air flow channel (15) arranged on one side (11.1) of the electronic support (11), said first air flow channel (15) being configured to guide a first part (F.1) of the environmental air (F),
- the first part (140) and the second part (141) of the cover (14) define a second air flow channel (16) arranged on the other side (11.2) of the electronic support (11), said second air flow channel (16) being configured to guide a second part (F.2) of the environmental air (F),
- said fan (13) is configured to drive the environmental air (F) through said first air flow channel (15) and through said second air flow channel (16) so that the environmental air (F) flows along both sides of the electronic support (11).

2. Telematics control unit (1) according to claim 1, wherein said fan (13) is arranged on a side (10.1) of the housing (10) and is an axial fan or a radial fan.

3. Telematics control unit (1) according to claim 1, wherein said fan (13) has an axis (C) that is tilted angle compared to a transversal axis (X) of the housing (10), said transversal axis (X) being perpendicular to the longitudinal axis (Y).

4. Telematics control unit (1) according to any of the preceding claims, wherein the first air flow channel (15) and the second air flow channel (16) extend along a transversal axis (X) that is perpendicular to the longitudinal axis (Y).

5. Telematics control unit (1) according to any of the preceding claims, wherein said fan (13) is configured to take the environmental air (F) from one side (10.1) of the housing (10) and to evacuate it from another other side (10.2) of the housing (10) outside said housing (10) through said first air flow channel (15) and said second air flow channel (16).

6. Telematics control unit (1) according to the preceding claim, wherein said housing (10) further comprises a recess (102) to receive the heatsink (12), said recess (102) having a slope (1020).

7. Telematics control unit (1) according to any of the preceding claims, wherein said housing (100) is of a metal material or of a thermoplastic material.

8. Telematics control unit (1) according to any of the preceding claims, wherein said cover (14) is of a thermoplastic material.

9. Telematics control unit (1) according to any of the preceding claims, wherein said heatsink (12) is a sheet of metal or a die casting part with fins.

10. Telematics control unit (1) according to any of the preceding claims, wherein said heatsink (12) is embedded or molded into the housing (10).

11. Telematics control unit (1) according to any of the preceding claims, wherein said first part (140) of the cover (14) comprises cooling fins (1400).

12. Telematics control unit (1) according to any of the preceding claims, wherein the plurality of electronic components (110) are disposed on one side (11.1) of the electronic support (11) or on both sides (11.1, 11.2) of the electronic support (11).

13. Telematics control unit (1) according to any of the preceding claims, wherein said second part (141) of the cover (14) is removable.

14. Telematics control unit (1) according to any of the preceding claims, wherein said electronic support (11) is a printed circuit board assembly.
